Europäisches Patentamt

(19) European Patent Office

Office européen des brevets

(11) Numéro de publication : **0 191 697**
**B1**

(12) **FASCICULE DE BREVET EUROPÉEN**

(45) Date de publication du fascicule du brevet :
09.08.89

(51) Int. Cl.⁴: **H 01 L 31/18, H 01 L 31/08**

(21) Numéro de dépôt : 86400257.1

(22) Date de dépôt : 07.02.86

(54) Procédé de réalisation d'un détecteur photoélectrique du type photorésistance de grande sensibilité.

(30) Priorité : 15.02.85 FR 8502258

(43) Date de publication de la demande :
20.08.86 Bulletin 86/34

(45) Mention de la délivrance du brevet :
09.08.89 Bulletin 89/32

(84) Etats contractants désignés :
DE GB IT NL

(56) Documents cités :
US–A– 3 972 770
US–A– 4 273 594
THIN SOLID FILMS, vol. 92, no. 3, juin 1982, pages 273-279, Elsevier Sequoia, Lausanne, CH; H.J. KLEIN et al.: "Ultrafast thin film GaAs photoconductive detectors"
IEEE TRANSACTIONS ON ELECTRON DEVICES, vol. ed-29, no. 9, septembre 1982, pages 1420-1431, New York, US; H. BENEKING: "Gain and bandwidth of fast near-infrared photodetectors: a comparison of diodes, phototransistors, and photoconductive devices"
JOURNAL OF THE ELECTOCHEMICAL SOCIETY, vol. 121, no. 9, septembre 1974, pages 1215-1219, Princeton, US; J.J. GANNON et al.: "A chemical etchant for the selective removal of GaAs through SiO2 masks"

(73) Titulaire : CENTRE NATIONAL DE LA RECHERCHE SCIENTIFIQUE (CNRS)
15, Quai Anatole France
F-75007 Paris (FR)

(72) Inventeur : Decoster, Didier
12, rue Joseph Leroy
F-59115 Leers (FR)
Inventeur : Fauquembergue, Renaud
5, Chemin Vert
F-62220 Carvin (FR)
Inventeur : Constant, Monique, née Flodrois
39, avenue du Vieux Château
F-59650 Villeneuve d'AsQ (FR)

(74) Mandataire : Levesque, Denys et al
Cabinet Beau de Loménie 55, rue d'Amsterdam
F-75008 Paris (FR)

**Description**

L'invention se rapporte à un procédé de réalisation d'un détecteur photoélectrique du type photorésistance comprenant sur un substrat une couche active d'arséniure de gallium dopé munie de deux électrodes à contacts ohmiques de connexion à un circuit de mise en œuvre.

On sait que la détection d'énergie lumineuse à l'aide de semiconducteurs est basée sur le fait qu'un photon d'énergie suffisante (supérieure à l'énergie de bande interdite du semiconducteur considéré) peut créer une paire électron-trou dans le semiconducteur. Si un champ électrique règle en son sein, les porteurs photoexcités sont entraînés et vont donner naissance à un courant que l'on peut recueillir dans un circuit extérieur : c'est le photocourant.

Un paramètre intéressant qui permet de donner une idée des performances du photodétecteur est le gain, et plus particulièrement le gain externe que l'on définit comme le nombre de charges électriques collectées dans le circuit extérieur par photon incident sur le photodétecteur. Cette définition du gain permet ainsi de tenir compte tant des pertes par réflexion à la surface de la zone active du semiconducteur que du rendement quantique interne.

On peut séparer les photodétecteurs en deux grandes classes qui sont les photodiodes et photorésistances.

Dans une photodiode, un photon actif ne donne naissance qu'à une seule charge électrique collectable dans le circuit extérieur. Le gain est donc nécessairement inférieur à l'unité. Cependant, en polarisant en inverse des photodiodes à une tension suffisamment élevée, il est possible de profiter du phénomène d'avalanche pour augmenter le gain. Il n'est cependant que de l'ordre de 1 000 à 10 000 dans les photodiodes à avalanche classiques.

Dans une photorésistance, les mécanismes de conduction de l'électricité sont tels qu'il peut y avoir un gain G dont la valeur est donnée par le rapport entre la durée de vie $\tau_v$ des porteurs photocréés et leur temps de transit $\tau_t$ pour parcourir la distance interélectrode (les électrodes nécessaires aux prises de contact définissent cette distance) :

$$G = \frac{\tau_v}{\tau_t} \qquad (1)$$

Le principe physique de ces photorésistances est assez bien connu. Pour des photorésistances réalisées en technologie planar et utilisant une couche active en arséniure de gallium (AsGa) dopée N, la durée de vie $\tau_v$ des porteurs photocréés est directement liée a potentiel de surface $\Psi$ du matériau semiconducteur par la relation :

$$\tau_v = \tau_0 \exp \frac{e\psi}{kT} \qquad (2)$$

où $\tau_0$ représente le temps moyen nécessaire aux trous pour traverser la zone de charge d'espace par agitation thermique, e est la charge de l'électron, k est la constante de Boltzmann et T la température absolue. Pour pouvoir détecter de très faibles niveaux lumineux, il convient d'augmenter le gain G, donc la durée de vie $\tau_v$ des porteurs. La formule (2) montre qu'il convient à cet effet :

d'éviter un échauffement de la couche active par effet Joule, et

d'augmenter son potentiel de surface.

L'invention a notamment pour but de définir un procédé permettant d'accroître la sensibilité d'une photorésistance du genre considéré par augmentation du potentiel de surface naturel de l'arséniure de gallium (AsGa) qui en constitue la couche active.

Le procédé selon l'invention est défini par les termes de la revendication 1.

De cette façon, le potentiel de surface naturel du matériau semi-conducteur, qui correspond environ à $e\Psi = 0,4$ eV, peut être augmenté jusqu'aux abords de sa valeur maximale théorique correspondant à la moitié de l'énergie de sa bande interdite, soit environ 0,6 à 0,8 eV. Le gain G variant, conformément aux relations (1) et (2), exponentiellement avec le potentiel de surface, une telle augmentation conduit à un accroissement considérable du gain de la photorésistance, pouvant atteindre plusieurs ordres de grandeur.

Le traitement précité est avantageusement un traitement chimique, consistant préférentiellement en une immersion de la couche active dans une solution composée

d'ammoniaque $NH_4OH$ (1 volume),

d'eau oxygénée $H_2O_2$ (1 volume),

et d'eau $H_2O$ (100 volumes),

pendant 20 secondes, à 25 °C et avec agitation. Ce traitement, qui fait probablement intervenir des processus d'oxydo-réduction impliquant des phénomènes de catalyse, cause la formation, à la surface du semi-conducteur, de trous à l'échelle atomique, de sorte que sur cette surface les atomes d'arsenic prennent une importance prépondérante par rapport aux atomes de gallium, ce qui crée une surface à forte charge négative (sans qu'il soit besoin par exemple d'y déposer un revêtement métallique et de porter celui-ci à un potentiel approprié).

D'autre part, en vue de diminuer le courant d'obscurité et donc d'éviter l'échauffement de la couche active par effet Joule, il convient de creuser, préalablement au traitement d'attaque sélective, un profond canal dans la couche active entre les deux électrodes de contact. Grâce à la présence de ce canal, qui peut être creusé par usinage ionique, le courant d'obscurité de la photorésistance est beaucoup plus faible, ce qui contribue à augmenter le gain de celle-ci.

Le procédé selon l'invention permet de réaliser des photorésistances dont le gain peut atteindre $10^9$ environ, comme on le verra plus loin. De telles photorésistances constituent ainsi une version à l'état solide des photomultiplicateurs classiques utilisés pour la détection de faibles niveaux de lumière.

D'autres caractéristiques et avantages de l'invention ressortiront plus clairement de la description qui va suivre, en regard des dessins annexés, d'un exemple de réalisation non limitatif.

La figure 1 représente, en coupe fortement grossie, la structure d'une photorésistance réalisée suivant le procédé selon l'invention.

La figure 2 montre les varaitions du courant d'obscurité de la photorésistance sans et avec canal creusé.

La figure 3 montre les variations du gain de photorésistances ayant subi des traitements différents.

La figure 4 montre les variations du gain relatif d'une photorésistance traitée conformément à l'invention, pour différentes puissances lumineuses incidentes.

Les figures 5 et 6 représentent schématiquement deux ensembles de mesure de lumière équipés respectivement d'un photomultiplicateur et d'une photorésistance selon l'invention.

les figures 7 et 8 montrent des enregistrements de spectres Raman obtenus respectivement avec les ensembles des figures 5 et 6.

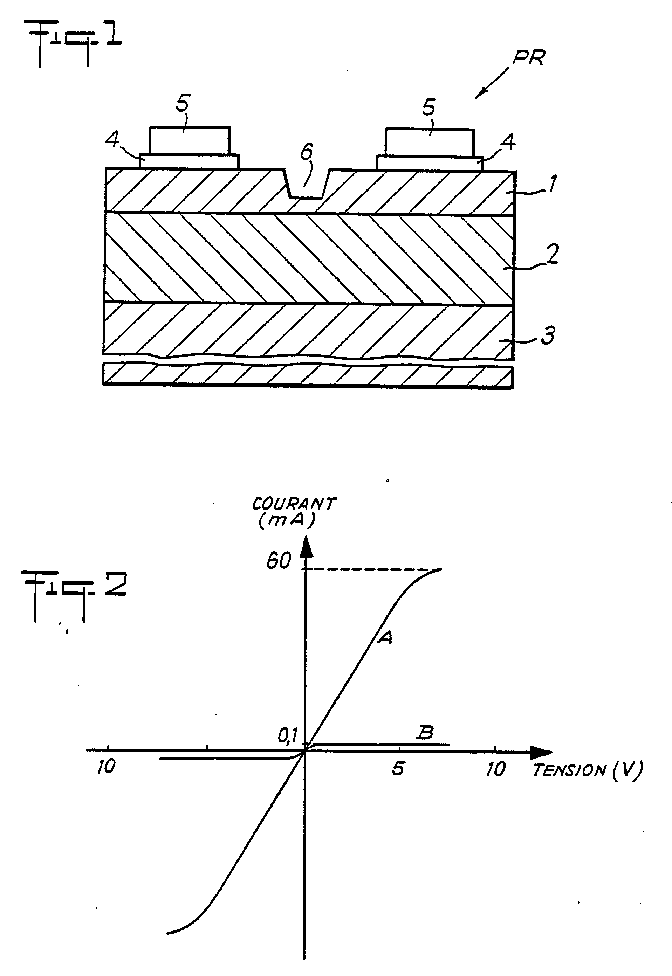

La photorésistance PR représentée à la fig. 1 comprend essentiellement une couche active 1, électro-optiquement sensible, portée par un substrat 3 avec interposition d'une couche intermédiaire 2. Ces trois couches sont en arséniure de gallium (AsGa). La couche 1, d'épaisseur égale à 0,2 µm, est en AsGa dopé N (taux d'impureté d'environ $9.10^{16}$ at./cm$^3$) ; la couche 2, d'épaisseur égale à 4 µm, est une couche-tampon en AsGa non intentionnellement dopé (taux d'impureté d'environ $10^{14}$ at./cm$^3$), et la couche 3, d'épaisseur égale à 400 µm, est en AsGa semi-isolant. Sur la surface libre de la couche 1 sont formées deux électrodes à contact ohmique, constituées par des pastilles 4 d'eutectique Au-Ge surmontées de plots d'or 5 qui permettent le soudage de fils de connexion. La distance des bords en regard des deux pastilles 4 est égale à 10 µm.

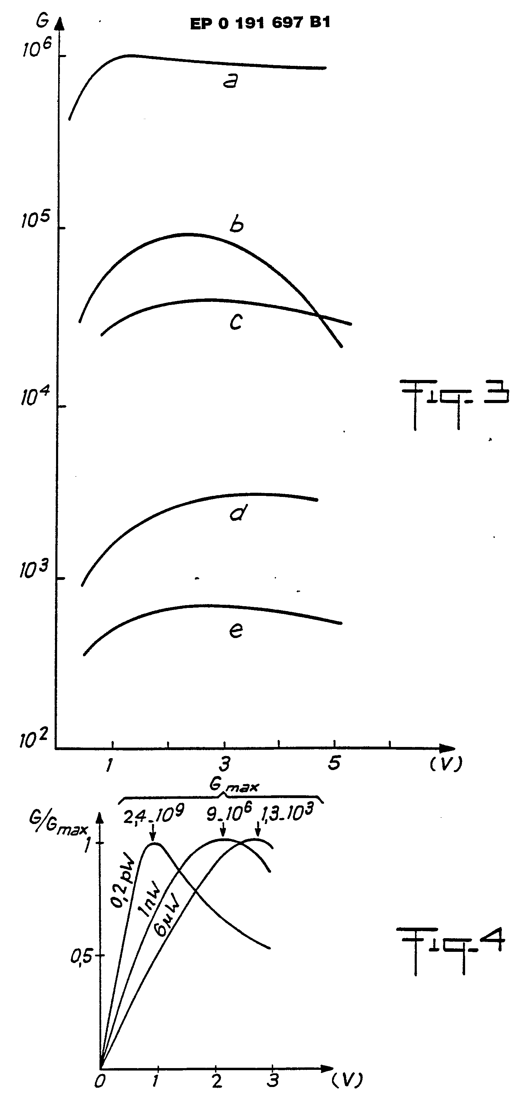

Un canal 6 est creusé, par traitement ionique, dans la couche active 1, entre les pastilles de contact 4, sur une largeur de 3µm et une profondeur de l'ordre de la moitié ou des deux tiers de l'épaisseur de ladite couche. La présence de ce canal cause une forte diminution du courant d'obscurité de la photorésistance, comme le montre la figure 2. Les variations du courant d'obscurité en fonction de la tension appliquée aux bornes 5 de la photorésistance suivent la courbe A en l'absence de canal 6 et la courbe B en présence de ce canal. On voit par exemple que pour une tension de 7,5 V le courant d'obscurité tombe de 60 mA à 0,1 mA. Le creusement d'un tel canal entraîne, grâce à l'abaissement du courant d'obscurité, un moindre échauffement du composant, dont les performances se trouvent améliorées.

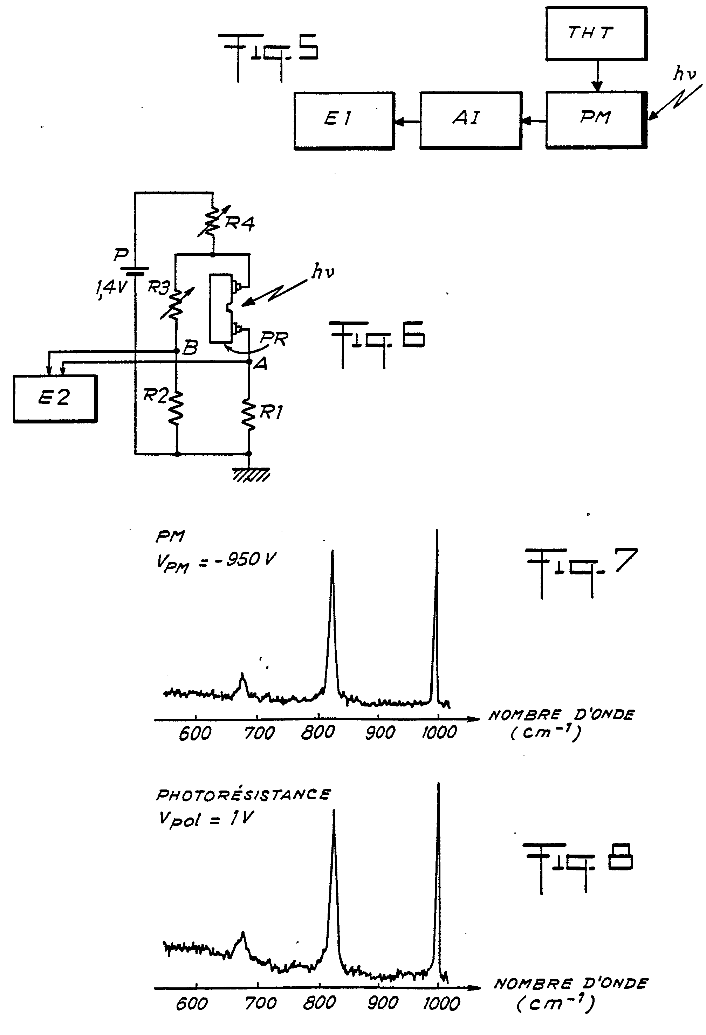

Le gain G d'une photorésistance ainsi réalisée en fonction de la tension appliquée à ses bornes, pour une puissance lumineuse de 100 nW, est donné par la courbe c de la figure 3. Il est de l'ordre de $3.10^4$.

La valeur du gain G peut être augmentée dans d'importantes proportions en soumettant la couche active 1 à un traitement superficiel qui réalise une attaque chimique sélective produisant un accroissement de son potentiel de surface. Différents essais en laboratoire ont montré que les meilleurs résultats sont obtenus en plongeant la couche active durant 20 secondes dans une solution composée de 1 volume de NH$_4$OH et de 1 volume de H$_2$O$_2$ dans 100 volumes d'eau et maintenue à 25 °C sous agitation. Ce traitement de surface modifie le degré de compensation de ladite surface en arsenic et en gallium et a pour effet d'augmenter la charge négative de surface, donc d'exalter le potentiel de surface. La durée choisie assure une attaque effective tout en évitant une modification trop importante de l'épaisseur de la couche active. Le choix de la température a été retenu afin de se placer dans des conditions expérimentales facilement reproductibles. En outre, la précaution d'agiter le bain est indispensable pour obtenir un traitement uniforme.

La mise en œuvre de ce traitement chimique sur la couche active 1 où a été creusé le canal 6 conduit, dans les mêmes conditions de mesure, à un gain de l'ordre de $10^6$ (courbe a de la figure 3).

A titre d'exemples, on a porté également sur la figure 3 la courbe b (gain allant de $3.10^4$ à $10^5$ environ) obtenue après le seul traitement chimique défini ci-dessus, sans traitement ionique de creusement de canal, la courbe d (gain allant de $10^3$ à $3.10^3$ environ) obtenue avec traitement ionique et traitement chimique, la solution de traitement contenant 15 volumes de NH$_4$OH (au lieu de 1 volume), et la courbe e (gain de l'ordre de $5.10^2$ seulement) avec traitement ionique et traitement chimique au moyen d'une solution contenant non pas de l'ammoniaque, mais de l'acide phosphorique PO$_4$H$_3$ (15 volumes). Dans tous les cas, la température de la solution de traitement chimique utilisée est maintenue à 25 °C, la durée d'immersion dans celle-ci restant égale à 20 secondes. Quant à la puissance lumineuse, elle est dans chaque cas égale à 100 nW.

Un examen comparatif de ces courbes montre l'augmentation considérable de gain qu'apporte la combinaison des traitements ionique (canal) et chimique (attaque superficielle), ainsi que l'importance que présente le respect des conditions préconisées pour le traitement chimique, notamment en ce qui concerne la composition de la solution.

Le gain d'une photorésistance dépend de la puissance lumineuse incidente. Si le gain de la photorésistance PR réalisé avec traitement ionique et chimique est voisin de $10^6$ sous une puissance lumineuse de 100 nW (courbe a de la figure 3), sa valeur peut atteindre et dépasser $10^9$ sous de plus faibles puissances incidences. La figure 4 montre ainsi des courbes de variation du gain relatif G/G max pour trois valeurs de puissance lumineuse (6 µWn 1 nW et 0,2 pW), les valeurs correspondantes de G max étant indiquées dans chaque cas, à savoir respectivement $1,3.10^3$, $9.10^6$ et $2,4.10^9$.

On voit que, pour de très faibles puissances lumineuses, le gain G de la photorésistance PR est comparable à celui d'un bon photomultiplicateur. Ce résultat a été confirmé par des essais comparatifs d'obtention de spectres Raman à l'aide d'une part d'un photomultiplicateur PM, d'autre part d'une photorésistance PR selon l'invention.

Le photomultiplicateur PM (figure 5), relié à une source d'alimentation THT, délivre un signal qui est appliqué, via un amplificateur-intégrateur AI à un enregistreur E1.

La photorésistance PR (figure 6) est montée dans un pont dont les branches sont constituées par des résistances R1, R2, R3 et la photorésistance elle-même, ce pont étant alimenté, via une résistance R4, par une pile P de 1,4 V. L'effet du courant d'obscurité est compensé par réglage de la résistance R3, tandis que les résistances R1 et R2 ont pour valeur 12 ohms. Le signal prélevé aux points A et B est appliqué à un enregistreur E2, identique à l'enregistreur E1.

Le photomultiplicateur PM (du type Hamamatsu R 268) et la photorésistance PR sont utilisés successivement comme photodétecteur à la sortie d'un même spectromètre recevant le rayonnement Raman d'un échantillon d'oxyde de molybdène $MoO_3$ excité par laser. Les figures 7 et 8 montrent les spectres respectivement obtenus (entre 550 et 1 000 $cm^{-1}$ environ), tels qu'ils ont été enregistrés. Il apparaît immédiatement que les résultats fournis par la photorésistance, associée à la pile de polarisation P et à quelques résistances, sont tout à fait comparables à ceux que procure le photomultiplicateur, associé à son alimentation stabilisée THT et à l'amplificateur-intégrateur AI.

On remarque en particulier que les intensités relatives des raies sont les mêmes dans les deux spectres, lesquels sont obtenus avec un rapport signal/bruit du même ordre de grandeur. Il est intéressant de noter en outre que le signal de sortie du photomultiplicateur (quelques nA) nécessite une amplification et un filtrage, alors que celui délivré par la photorésistance ($10^{-3}$ à $10^{-5}$ A) ne subit aucun traitemnt. De plus, dans le domaine des basses fréquences, le bruit de la photorésistance ne semble pas supérieur à celui du photomultiplicateur.

En conclusion, on voit que la photorésistance creusée et traitée chimiquement selon l'invention présente des gains en continu tout à fait comparables à ceux d'un photomultiplicateur de qualité, auquel elle peut être considérée comme équivalente et qu'elle peut avantageusement remplacer, permettant ainsi une très importante économie de matériel, d'encombrement et de puissance d'alimentation électrique.

## Revendications

1. Procédé de réalisation d'un détecteur photoélectrique du type photorésistance comprenant sur un substrat (3) une couche active d'arséniure de gallium dopé (1) munie de deux électrodes à contacts (4) ohmiques de connexion à un circuit de mise en œuvre, caractérisé en ce qu'il comporte une étape d'attaque sélective de la surface de ladite couche active modifiant son degré de compensation en gallium et en arsenic de façon à augmenter la charge négative de surface.

2. Procédé selon la revendication 1, caractérisé par le fait que le traitement précité est un traitement chimique.

3. Procédé selon la revendication 2, caractérisé par le fait que le traitement chimique consiste en une immersion de la couche active (1) dans une solution composée :

d'ammoniaque $NH_4OH$ (1 volume)
d'eau oxygénée $H_2O_2$ (1 volume),
et d'eau $H_2O$ (100 volumes),

pendant 20 secondes, à 25 °C et avec agitation.

4. Procédé selon l'une quelconque des revendications 1 à 3, caractérisé par le fait que, préalablement au traitement d'attaque sélective, un profond canal (6) est creusé dans la couche active entre les deux électrodes de contact (4).

5. Procédé selon la revendication 4, caractérisé par le fait que le canal (6) est creusé par usinage ionique.

## Claims

1. Process for producing a photoelectric detector of the photoresistor type comprising on a substrate (3) an active layer of doped gallium arsenide (1) provided with two electrodes (4) with ohmic contacts for connection to a user circuit, characterised in that it includes a stage of treatment producing a selective attack of the surface of said active layer modifying its degree of compensation in gallium and in arsenic so as to increase the negative surface charge.

2. Process according to claim 1, characterised in that the above treatment is a chemical treatment.

3. Process according to claim 2, characterised in that the above treatment consists of immersing said active layer (1) in a solution containing :

ammonia $NH_4OH$ (1 volume),

hydrogen peroxide $H_2O_2$ (1 volume),

and water $H_2O$ (100 volumes)

for 20 seconds, at 25 °C and with stirring.

4. Process according to any one of claims 1 to 3, characterized in that, prior to the selective attack treatment, a deep channel (6) is hollowed out in the active layer between the two contact electrodes (4).

5. Process according to claim 4, characterised in that the deep channel (6) is hollowed out by ionic machining.


**Patentansprüche**

1. Verfahren zur Herstellung eines photoelektrischen Detektors vom Typ Photowiderstand mit auf einem Substrat (3) einer aktiven dotierten Galliumarsenidschicht (1), auf der zwei Verbindungselektroden (4) mit Ohmschem Kontakt zu einem Betriebskreis aufgebracht sind, gekennzeichnet durch eine Behandlungsstufe, die einen selektiven Angriff der Oberfläche der aktiven Schicht bewirkt, wobei ihr Kompensationsgrad in Gallium und Arsen verändert und die negative Flächenladung erhöht wird.

2. Verfahren nach Anspruch 1, dadurch gekennzeichnet, dass die gennante Behandlung eine chemische Behandlung ist.

3. Verfahren nach Anspruch 2, dadurch gekennzeichnet, dass die chemische Behandlung während 20 s bei 25 °C und unter Rühren durch Eintauchen der aktiven Schicht (1) in eine Lösung aus

Ammoniak $NH_4OH$ (1 Volumen)

Wasserstoffperoxyd $H_2O_2$ (1 Volumen) und

Wasser $H_2O$ (100 Volumina)

durchgeführt wird.

4. Verfahren nach einem der Ansprüche 1-3, dadurch gekennzeichnet, dass vor der selektiven Angriffsbehandlung ein tiefer Kanal (6) in die aktive Schicht zwischen den beiden Kontaktelektroden (4) gegraben wird.

5. Verfahren nach Anspruch 4, dadurch gekennzeichnet, dass der Kanal (6) durch Ionenbehandlung gegraben wird.

Fig.1

Fig.2

EP 0 191 697 B1

Fig. 3

Fig. 4

Fig.5

THT

E1 ← AI ← PM ← hv

Fig.6

P
1,4V  R3  R4

B
A  PR
hv

E2  R2  R1

Fig.7

PM
$V_{PM} = -950\,V$

NOMBRE D'ONDE
($cm^{-1}$)

600  700  800  900  1000

Fig.8

PHOTORÉSISTANCE
$V_{pol} = 1\,V$

NOMBRE D'ONDE
($cm^{-1}$)

600  700  800  900  1000